Europäisches Patentamt

European Patent Office

Office européen des brevets

(11) Veröffentlichungsnummer: **0 402 519 B1**

# (12) EUROPÄISCHE PATENTSCHRIFT

(45) Veröffentlichungstag der Patentschrift: **01.06.94**

(21) Anmeldenummer: **89111019.9**

(22) Anmeldetag: **16.06.89**

(51) Int. Cl.⁵: **H03H 21/00**

(54) **Verfahren und Anordnung zur Verbesserung des Dynamikbereichs eines adaptiven rekursiven Netzwerks zur Verarbeitung zeitdiskreter Signale.**

(43) Veröffentlichungstag der Anmeldung:
**19.12.90 Patentblatt 90/51**

(45) Bekanntmachung des Hinweises auf die
Patenterteilung:
**01.06.94 Patentblatt 94/22**

(84) Benannte Vertragsstaaten:
**DE FR GB IT NL**

(56) Entgegenhaltungen:

**PROCEEDINGS OF THE IEEE, Band 64, Nr. 11, November 1976, Seiten 1583-1597, New York, US; MAN MOHAN SONDHI et al.: "New results on the performance of a well-known class of adaptive filters"**

**INTERNATIONAL CONFERENCE ON DIGITAL SIGNAL PROCESSING, 30. August - 2. September 1978, Florence, IT, Seiten 1-8; S. HORVATH: "A new adaptive recursive LMS filter"**

(73) Patentinhaber: **SIEMENS AKTIENGESELL-SCHAFT**
**Wittelsbacherplatz 2**
**D-80333 München(DE)**

(72) Erfinder: **Gazsi, Lajos, Dr.-Ing.**
**Faunastrasse 23**
**D-4000 Düsseldorf(DE)**
Erfinder: **Brückmann, Dieter, Dr.-Ing.**
**Zur Lindung 9**
**D-4000 Düsseldorf(DE)**

EP 0 402 519 B1

EP 0 402 519 B1

**Beschreibung**

Die Erfindung betrifft ein Verfahren zur Verbesserung des Dynamikbereichs eines adaptiven rekursiven Netzwerks zur Verarbeitung zeitdiskreter Signale nach dem Oberbegriff des Patentanspruchs 1 und eine Anordnung zur Durchführung des Verfahrens.

Adaptive Netzwerke, wie etwa adaptive Digitalfilter, sind in vielen Bereichen der zeitdiskreten Signalverarbeitung, insbesondere in den Bereichen Systemanalyse, Echokompensation bei Zweidraht-Vierdrahtübergängen, Leitungsentzerrung und Sprachverarbeitung, von großer Bedeutung. Das Charakteristikum solcher adaptiver Netzwerke ist, im Vergleich zu konstanten Netzwerken, daß die Netzwerkparameter, die die Übertragungseigenschaften bestimmen, gegenüber einem Gütefunktional optimal eingestellt werden. Ein derartiges Gütefunktional ist beispielsweise dadurch gegeben, daß der mittlere quadratische Fehler des Ausgangssignals des adaptiven Netzwerks gegenüber einem Referenzsignal minimiert wird. Mit Hilfe verschiedener Verfahren lassen sich die Parameter automatisch auf den gewünschten Wert einstellen. Aus D. A. Pierre, "Optimization Theory with Applications", John Wiley and Sons, New York, 1969, ist beispielsweise ein Verfahren bekannt, bei dem die partiellen Ableitungen (Gradient) des Gütefunktionals nach den zu adaptierenden Netzwerkparametern gebildet werden. Für die meisten Gütekriterien ist dieses Verfahren zurückführbar auf die Bildung der partiellen Ableitungen des Ausgangssignals des adaptiven Netzwerks nach den Netzwerkparametern.

Ein derartiges Verfahren wird beispielsweise in dem nicht vorveröffentlichten Dokument EP-A-0 397 912, veröffentlicht am 22.11.1990 beschrieben. Dort werden die partiellen Ableitungen des Ausgangssignals des adaptiven Netzwerks nach den einzelnen Parametern mit Hilfe eines Gradientennetzwerks berechnet.

Ein typisches Beispiel für rekursive Netzwerke zur Verarbeitung zeitdiskreter Signale sind Wellendigitalfilter, die sich neben der Realisierung von festen Übertragungsfunktionen auch hervorragend zur Implementierung von adaptiven Systemen eignen. Wellendigitalfilter enthalten Verzögerungen sowie Adaptoren. Die Adaptoren wiederum sind aus Addierern bzw. Subtrahierern sowie Multiplizierern, d.h. Verstärkern aufgebaut. Mit Hilfe der Multipliziererkoeffizienten können unterschiedliche Übertragungsfunktionen eingestellt werden. Bei einem adaptiven Wellendigitalfilter stellen die Multipliziererkoeffizienten die Netzwerkparameter dar, die variabel sind und sich automatisch auf die gewünschten Werte einstellen. Gradientennetzwerke können ebenfalls durch Wellendigitalfilter realisiert werden.

Bei Netzwerken der genannten Art müssen zur Modifizierung der einzelnen zu adaptierenden Parameter Korrekturterme bzw. Korrektursignale gebildet werden. Diese Korrektursignale ergeben sich aus den Produkten der Gradientensignale, d. h. der partiellen Ableitungen der Netzwerkausgangssignale nach den einzelnen Parametern, mit Differenzsignalen, die durch einen Vergleich der Filterausgangssignale mit Sollsignalen gebildet werden. Die so gebildeten Produktsignale müssen grundsätzlich mit einem zusätzlichen Dämpfungsfaktor K multipliziert werden, um unter allen Umständen Stabilität in der Modifizierungsschleife zu gewährleisten. Die Modifizierungsschleife wird dadurch gebildet, daß die Korrektursignale in einem Netzwerk weiter verarbeitet werden, das die aktuellen Werte für die einzelnen Parameter bestimmt und das diese aktuellen Parameterwerte dann in dem adaptiven Netzwerk bzw. dem Gradientennetzwerk einstellt.

Probleme können bei adaptiven Netzwerken der genannten Art hinsichtlich der Skalierung auftreten, wenn der darstellbare Wertebereich gegeben ist und beispielsweise der Zahlenbereich auf $- 1 \leq x \leq 1\text{-}2^{-n}$ mit der Wortlänge n beschränkt ist (Festkommaarithmetik). Bei der durch das adaptive System bedingten Veränderung der Parameter muß die Aussteuerbarkeit des Netzwerks zur Realisierung der gewünschten Übertragungsfunktion im definierten Bereich bleiben, so daß keine Sättigungseffekte auftreten können. Der Dämpfungsfaktor K ergibt sich aus Leistungsbetrachtungen und wird so gewählt, daß selbst unter den ungünstigsten Verhältnissen, also maximale Werte der Eingangs- und Gradientensignale, Stabilität sichergestellt ist. Üblicherweise wird der Dämpfungsfaktor K als Kehrwert der doppelten Anzahl der zu adaptierenden Parameter gewählt.

Bei diesem auf die ungünstigsten Verhältnisse abgestimmten Wert des Dämpfungsfaktors K wird die Adaptionsgeschwindigkeit bei kleinen Signalpegeln der Eingangs- und/oder Gradientensignale entsprechend langsamer, weil die von diesen Signalen abhängigen Korrektursignale für die Parameter kleiner werden. Eine Verbesserung läßt sich erzielen, wenn die Leistung der Gradientensignale bestimmt und die Korrektursignale für die Parameter mit dem reziproken Wert dieser Leistung multipliziert werden. Dieses Verfahren ist jedoch bei Netzwerken mit beschränktem Zahlenbereich mit großem Aufwand verbunden.

Aus der Veröffentlichung M. Sondhi, D. Mitra "New Results on the Performance of a Well-Known Class of Adaptive Filters", Proceedings IEEE, Vol.64, No.11, pp. 1583-1597, Nov. 1976 ist für adaptive "Finite-Impulse-Response (FIR)-Filter", d. h. für nichtrekursive Netzwerke, ein Verfahren bekannt, bei dem die Korrektursignale für die Parameter proportional zum Produkt der Signale der Signumfunktion der Differenz-

2

signale und der Gradientensignale gewählt werden. Dieses Verfahren hat jedoch den entscheidenden Nachteil, daß der Proportionalitätsfaktor sehr klein gewählt werden muß, damit die Parameter im adaptierten Zustand keinen großen Änderungen unterliegen. Im übrigen lassen sich nichtrekursive Netzwerke nicht auf rekursive Netzwerke übertragen, da diese wesentlich komplexer sind.

Der Erfindung liegt die Aufgabe zugrunde, ein Verfahren zur Verbesserung des Dynamikbereichs eines adaptiven rekursiven Netzwerks der eingangs genannten Art sowie eine Anordnung zur Durchführung des Verfahrens anzugeben.

Diese Aufgabe wird bei einem gattungsgemäßen Verfahren durch die kennzeichnenden Merkmale des Patentanspruchs 1 gelöst. Weiter wird die Aufgabe mit einer Anordnung gemäß den kennzeichnenden Merkmalen des Patentanspruchs 3 gelöst.

Die Erfindung hat den Vorteil, daß sie bei adaptiven rekursiven Netzwerken zur Verarbeitung zeitdiskreter Signale einen großen Dynamikbereich bei stabilem Netzwerkverhalten ermöglicht. Als Folge ergibt sich ein gutes Rauschverhalten bei optimaler Ausnutzung des Skalierungsbereichs. Weiter besitzt die Erfindung den Vorteil, daß sie eine Verringerung des Realisierungsaufwands für das oder die Gradientennetzwerke ermöglicht.

Ausgestaltungen des Erfindungsgedankens sind in Unteransprüchen gekennzeichnet.

Die Erfindung wird nachfolgend anhand von in den Figuren der Zeichnung dargestellten Ausführungsbeispielen näher erläutert. Es zeigt:

FIG 1     ein Prinzipschaltbild eines erfindungsgemäßen adaptiven rekursiven Netzwerks,

FIG 2     ein Prinzipschaltbild einer Versuchsanordnung mit einem erfindungsgemäßen Netzwerk und

FIG 3     ein Diagramm mit dem Ausgangssignal eines bekannten Netzwerks im Vergleich zu dem Ausgangssignal eines Netzwerks nach Figur 2.

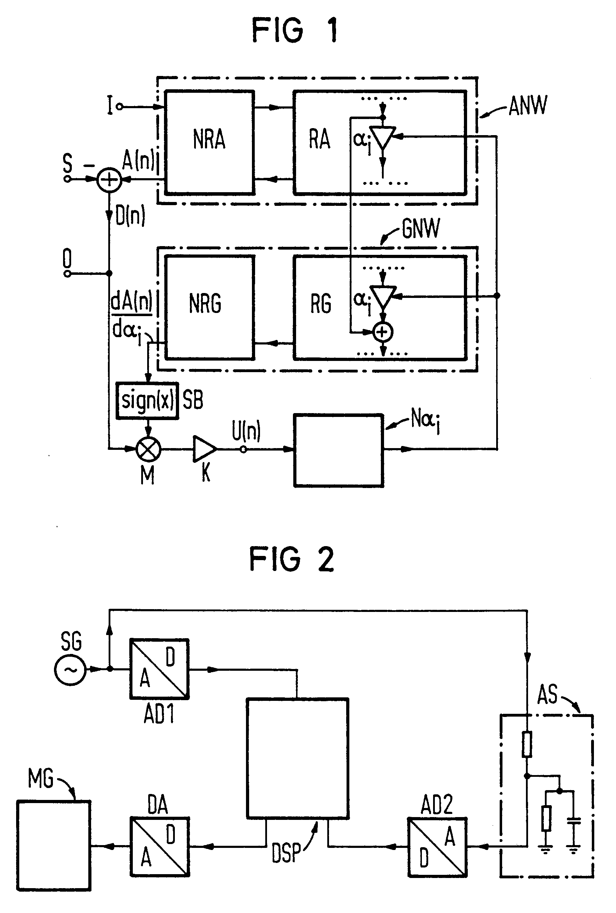

Gemäß Figur 1 ist das adaptive rekursive Netzwerk aus mehreren Teilnetzwerken aufgebaut. Das eigentliche adaptive Netzwerk ANW enthält einen rekursiven Teil RA, der von den Parametern $\alpha_i$ des Netzwerks abhängt und einen nichtrekursiven Teil NRA, der an Eingängen I Eingangssignale empfängt und an Ausgängen Ausgangssignale A(n) abgibt. Der rekursive und der nichtrekursive Netzwerksteil sind zur Übertragung von Signalen miteinander verbunden.

Jedes zum adaptiven Netzwerk ANW gehörende Gradientennetzwerk GNW besteht ebenfalls aus einem rekursiven und einem nichtrekursiven Teilnetzwerk RG bzw. NRG. Das rekursive Teilnetzwerk RG hängt dabei ebenfalls von den Parametern $\alpha_i$ ab. Zur Bildung der Gradientensignale $dA(n)/d\alpha_i$ der Ausgangssignale A(n) des adaptiven Netzwerks ANW empfängt das rekursive Gradienten-Teilnetzwerk RG Signale vom rekursiven adaptiven Teilnetzwerk RA. Nach der Verarbeitung der Ausgangssignale des Netzwerks RG im nichtrekursiven Netzwerksteil NRG stehen an dessen Ausgang Gradientensignale $dA(n)/d\alpha_i$ zur Verfügung. Es können jeweils sowohl ein als auch mehrere Ein- bzw. Ausgangssignale für das adaptive Netzwerk ANW vorgesehen sein. Die Anzahl der Gradientensignale richtet sich nach den Ausgangssignalen und der Anzahl der Parameter. Die Gradientensignale sind dabei die partiellen Ableitungen der Ausgangssignale nach den einzelnen Netzwerkparametern.

Zur Vereinfachung der Darstellung ist in Figur 1 nur ein Gradientennetzwerk für den Parameter $\alpha_i$ dargestellt. Das Netzwerk gemäß Figur 1 ist als adaptives Wellendigitalfilter angedeutet, das aus Addierern und Multiplizierern besteht, und das sowohl für das adaptive Netzwerk als auch für die Gradientennetzwerke vorgesehen werden kann.

Aus dem oder den Ausgangssignalen A(n) werden durch Vergleich mit Signalen eines Solleingangs S Fehler- oder Differenzsignale D(n) gebildet, wie dies schematisch durch den nicht näher bezeichneten Subtrahierer angedeutet ist. Das Differenzsignal D(n) liegt einerseits an einem Ausgang O der Netzwerkanordnung und andererseits an einem Eingang eines Multiplizierers M an. Der andere Eingang des Multiplizierers M ist mit einer Anordnung SB zur Bildung der Signumfunktion verbunden. Als Eingangssignal für den Signumbildner SB dient das oder die Gradientensignale $dA(n)/d\alpha_i$. Dem Multiplizierer M ist ein Verstärker mit der Verstärkung K nachgeschaltet, der das oder die Korrektursignale U(n) liefert. Die Korrektursignale werden einem Netzwerk $N\alpha_i$ zugeführt, das aus den Korrektursignalen mit Hilfe bekannter Verfahren die aktuellen Werte für die Parameter $\alpha_i$ des adaptiven und der gradientenbildenden Netzwerke ermittelt.

Die Korrektursignale U(n) ergeben sich somit als Produkt aus dem Faktor K des Verstärkers, dem Differenzsignal D(n) und der Signumfunktion des Gradientensignals bezüglich des jeweiligen Parameters. Die Signumfunktion ist dabei so definiert, daß ihr Wert gleich +1 ist für Agumente >0, daß ihr Wert gleich -1 ist für Argumente <0 und daß ihr Wert für das Argument 0 gleich 0 beträgt. Das Argument der Signale ist im Bereich der ganzen Zahlen definiert. Der Dämpfungsfaktor K entspricht vorzugsweise der doppelten Anzahl m der zu adaptierenden Parameter bzw. Koeffizienten $\alpha_i$. Damit ergeben sich folgende Gleichungen:

$$U(n) = K \cdot D(n) \cdot \text{sign} \left\{ \frac{dA(n)}{d\alpha_i} \right\} \qquad (1)$$

$$\text{sign}(x) = \begin{cases} +1 & \text{für } x > 0 \\ 0 & \text{für } x = 0 \\ -1 & \text{für } x < 0, \end{cases} \qquad (2)$$

$$K = \frac{1}{2m}, \qquad (3)$$

$$n = \dots -1, 0, +1 \dots \qquad (4)$$

$m$ = Anzahl der Adaptionsparameter $\alpha_i$.

Aus diesen Gleichungen, insbesondere Gleichung (1) wird deutlich, daß für die Korrektursignale $U(n)$ erfindungsgemäß nur die Vorzeichen der Gradientensignale benötigt werden. Daraus folgt, weil der Dämpfungsfaktor $K$ üblicherweise gegenüber der aus dem Stand der Technik bekannten Beziehung unverändert erhalten bleibt, daß die Korrektursignale grundsätzlich wesentlich größer als beim Stand der Technik sind. Gleichzeitig wird volle Stabilität der Netzwerkanordnung erhalten. Auf diese Weise ergibt sich eine erhebliche Verbesserung des Dynamikbereiches der Netzwerkanordnung. Ein weiterer Vorteil des erfindungsgemäßen Verfahrens bzw. einer erfindungsgemäßen Anordnung besteht darin, daß sich für die Gradientenfilter Vereinfachungen dadurch ergeben, daß in den nichtrekursiven Teilen NRG nur mit einem bit Genauigkeit gearbeitet werden muß.

Zur Erläuterung des erfindungsgemäßen Verfahrens zeigt Figur 2 einen Versuchsaufbau mit einer erfindungsgemäßen adaptiven rekursiven Netzwerkanordnung gemäß Figur 1, die auf einem digitalen Signalprozessor DSP implementiert wurde. Die adaptive rekursive Netzwerkanordnung arbeitet nach dem erfindungsgemäßen Verfahren. Der Signalpropzessor DSP ist über zwei Analog- Digital-Wandler AD1 und AD2 und einen Digital-Analog-Wandler DA mit der analogen Außenwelt verbunden. Gespeist wird das System von einem Sinusgenerator SG, dessen Frequenz im Bereich von 0 - 4 kHz durchgewobbelt wird. Das Ausgangssignal des Sinusgenerators SG dient sowohl als Eingangssignal für die analoge Übertragungsstrecke AS als auch über den Analog-Digital-Wandler AD1 als Referenzsignal für den digitalen Signalprozessor DSP. Die analoge Übertragungsstrecke AS ist symbolisch durch einen komplexen Spannungsteiler dargestellt. Das von dieser Übertragungsstrecke AS reflektierte Signal wird über einen zweiten Analog-Digital-Wandler AD2 als Echosignal ebenfalls in den Signalprozessor DSP eingespeist. Der Signalprozessor enthält als adaptive rekursive Netzwerksanordnung einen Echokompensator, der aus einem Wellendigitalfilter mit der Abtastrate 8 kHz besteht und dessen Übertragungsfunktion im Frequenzbereich von 0-4 kHz möglichst gut mit der analogen Übertragungsfunktion übereinstimmen soll. Bei einem Wellendigitalfilter entsprechen den adaptiven Parametern die Multipliziererkoeffizienten.

Die Differenz zwischen dem Netzwerks- bzw. Filterausgangssignal und dem Echosignal bildet das Differenzsignal, das über den Digital-Analog-Wandler DA als Fehlersignal ausgegeben wird und mit einem Meßgerät MG aufgezeichnet werden kann.

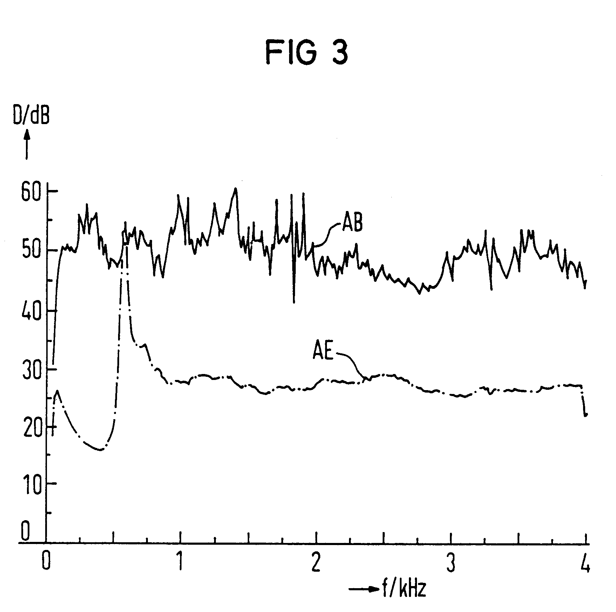

Figur 3 zeigt anhand eines Diagramms mit zwei Meßkurven die erzielte Echodämpfung D mit einem adaptiven Wellendigitalfilter erster Ordnung mit drei Koeffizienten $\alpha_i$. Der Signalverlauf AB ergibt sich bei den bekannten Verfahren zur Erzeugung der Korrektursignale. Der Signalverlauf AE ergibt sich beim Einsatz des erfindungsgemäßen Verfahrens zur Bildung der Korrektursignale. Erkennbar zeichnet sich der Signalverlauf AE durch eine erheblich bessere Dämpfung als der mit dem bekannten Verfahren erzielte Signalverlauf AB aus. Darüberhinaus ist der erforderliche Aufwand gegenüber dem bekannten Verfahren geringer.

**Patentansprüche**

1. Verfahren zur Verbesserung des Dynamikbereichs eines adaptiven rekursiven Netzwerks (ANW) zur Verarbeitung zeitdiskreter Signale, bei dem Ausgangssignale $A(n)$ des Netzwerks mit Sollsignalen S unter Bildung von Differenzsignalen $D(n)$ verglichen und diese wiederum mit aus den Ausgangssignalen $A(n)$ des Netzwerks bezüglich der Netzwerkparameter $\alpha_i$ gebildeten Gradientensignalen $dA(n)/d\alpha_i$ zur

EP 0 402 519 B1

Bildung von Korrektursignalen U(n) verknüpft werden, **dadurch gekennzeichnet,** daß das jeweilige Korrektursignal U(n) proportional zum Produkt aus dem Signal der Signumfunktion sign(x) des zugeordneten Gradientensignals $dA(n)/d\alpha_i$ und dem zugeordneten Differenzsignal D(n) gebildet wird.

2. Verfahren nach Anspruch 1, **dadurch gekennzeichnet,** daß der Proportionalitätsfaktor K für das Korrektursignal U(n) aus dem Kehrwert der doppelten Anzahl m zu adaptierender Parameter $\alpha_i$ des Netzwerks (ANW) gebildet wird.

3. Anordnung zur Verbesserung des Dynamikbereichs eines adaptiven rekursiven Netzwerks (ANW) zur Verarbeitung zeitdiskreter Signale mit Mitteln zum Vergleich der Ausgangssignale A(n) des Netzwerks mit Sollsignalen S unter Bildung von Differenzsignalen D(n) und Mitteln zur Bildung von Korrektursignalen U(n) durch Verknüpfung der Differenzsignale D(n) mit aus den Ausgangssignalen A(n) des Netzwerks bezüglich der Netzwerkparameter $\alpha_i$ gebildeten Gradientensignalen $dA(n)/d\alpha_i$, **dadurch gekennzeichnet,** daß Mittel (SB) zur Bildung der Signumfunktion sign(x) vorgesehen sind, die jeweils eingangsseitig ein Gradientensignal $dA(n)/d\alpha_i$ empfangen und ausgangsseitig mit einem Multiplizierer (M), der ein zugeordnetes Differenzsignal D(n) empfängt, verbunden sind, wobei das jeweilige Korrektursignal U(n) dem Ausgangssignal der Multiplizierers (M) proportional ist.

4. Anordnung nach Anspruch 3, **dadurch gekennzeichnet,** daß dem Multiplizierer (M) ein Verstärker nachgeschaltet ist, dessen Verstärkungsfaktor K dem Kehrwert der doppelten Anzahl m der zu adaptierenden Parameter $\alpha_i$ des Netzwerks ANW entspricht.

5. Anordnung nach Anspruch 3 oder 4, **dadurch gekennzeichnet,** daß die Gradientensignale $dA(n)/\alpha_i$ mit Hilfe jeweils eines Gradientennetzwerks (GNW) gebildet werden, das einen rekursiven und einen die Gradientensignale abgebenden nichtrekursiven (RG, NRG) Netzwerkteil enthält.

**Claims**

1. Method for improving the dynamic range of an adaptive recursive network (ANW) for processing time-discrete signals, in which output signals A(n) of the network are compared with nominal signals S, forming different signals D(n), and these different signals, in turn, are logically combined with gradient signals $dA(n)/d\alpha_i$ formed from the output signals A(n) of the network with respect to the network parameters $\alpha_i$ for forming correction signals U(n), characterized in that the respective correction signal U(n) is formed proportionally to the product of the signal of the signum function sign(x) of the associated gradient signal $dA(n)/d\alpha_i$ and the associated difference signal D(n).

2. Method according to Claim 1, characterized in that the proportionality factor K for the correction signal U(n) is formed from the inverse value of twice the number m of parameters $\alpha_i$ to be adapted of the network (ANW).

3. Arrangement for improving the dynamic range of an adaptive recursive network (ANW) for processing time-discrete signals with means for comparing the output signals A(n) of the network with nominal signals S, forming different signals D(n), and means for forming correction signals U(n) by logically combining different signals D(n) with gradient signals $dA(n)/d\alpha_i$ formed from the output signals A(n) of the network with respect to the network parameters $\alpha_i$, characterized in that means (SB) for forming the signum function sign(x) are provided which in each case receive a gradient signal $dA(n)/d\alpha_i$ at the input end and are connected at the output end to a multiplier (M) which receives an associated difference signal D(n), the respective correction signal U(n) being proportional to the output signal of the multiplier (M).

4. Arrangement according to Claim 3, characterized in that the multiplier (M) is followed by an amplifier, the gain factor K of which corresponds to the inverse value of twice the number m of parameters $\alpha_i$ to be adapted of the network ANW.

5. Arrangement according to Claim 3 or 4, characterized in that the gradient signals $dA(n)/\alpha_i$ are formed with the aid of in each case one gradient network (GNW) which contains a recursive network section and a non-recursive (RG, NRG) network section outputting the gradient signals.

5

**Revendications**

1. Procédé pour améliorer la zone dynamique d'un réseau (ANW) récursif adaptatif pour le traitement de signaux à valeurs discrètes dans le temps, dans lequel des signaux de sortie A(n) du réseau sont comparés à des signaux de consigne S, moyennant la formation de signaux différentiels D(n) et ces derniers sont à nouveau combinés avec des signaux de gradients $dA(n)/d\alpha_i$ formés à partir des signaux de sortie A(n) du réseau en ce qui concerne les paramètres de réseau $\alpha_i$, pour la formation de signaux de correction U(n), caractérisé en ce que chaque signal de correction U(n) est proportionnel au produit du signal de la fonction signe sign(x) du signal de gradient associé $dA(n)/d\alpha_i$ par le signal différentiel associé D(n).

2. Procédé suivant la revendication 1, caractérisé en ce que le facteur de proportionnalité K pour le signal de correction U(n) est obtenu à partir de l'inverse du nombre double m sur le paramètre d'adaptation $\alpha_i$ du réseau (ANW).

3. Dispositif pour améliorer la zone dynamique d'un réseau (ANW) adaptatif et récursif pour le traitement de signaux à valeurs discrètes dans le temps, comportant des moyens de comparaison des signaux de sortie A(n) du réseau avec des signaux de consigne S, moyennant la formation de signaux différentiels D(n), et comportant des moyens de formation de signaux de correction U(n) par combinaison des signaux différentiels D(n) avec les signaux de gradient $dA(n)/d\alpha_i$ formés à partir des signaux de sortie A(n) du réseau concernant le paramètre de réseau $\alpha_i$,
caractérisé en ce qu'il est prévu des moyens (SB) de formation de la fonction signe sign(x), qui reçoivent, côté entrée, un signal de gradient $dA(n)/d\alpha_i$ et qui sont reliés, côté sortie, à un multiplicateur (M), qui reçoit un signal différentiel D(n) associé, chaque signal de correction U(n) étant proportionnel au signal de sortie du multiplicateur (M).

4. Dispositif suivant la revendication 3, caractérisé en ce qu'en aval du multiplicateur (M), est branché un amplificateur, dont le facteur d'amplification (K) correspond à l'inverse du nombre double m du paramètre $\alpha_i$ à adapter du réseau ANW.

5. Dispositif suivant la revendication 3 ou 4, caractérisé en ce que les signaux de gradient $dA(n)/\alpha_i$ sont obtenus à l'aide d'un réseau de gradient (GNW), qui comporte une partie de réseau récursive et une partie de réseau non récursive (RG, NRG) fournissant les signaux de gradient.

## FIG 1

## FIG 2

# FIG 3